# EUROPÄISCHE PATENTANMELDUNG

(11) **EP 0 534 290 A2**
(43) Veröffentlichungstag der Anmeldung: **31.03.1993**
(21) Anmeldenummer: 92115791.3
(22) Anmeldetag: 16.09.1992
(51) Int. Cl.: H05K 3/00

(54) **Starre, in Teilbereichen biegbare Gedruckte Schaltungen und Verfahren zu deren Herstellung**

(30) Priorität: 25.09.1991 DE 4131935
(71) Anmelder: Degussa Aktiengesellschaft, D-60311 Frankfurt (DE); Schoeller & Co. Elektronik GmbH, D-35083 Wetter (DE)
(72) Erfinder: Münzberg, Roland, W-3575 Kirchhain (DE)
(74) Vertreter: Weber, Wolfgang

(57) **Zusammenfassung**

Starr-flexible Schaltungen müssen in vielen Fällen im flexiblen Bereich nicht dauerflexible sein, sondern es genügen Bereiche, die eine begrenzte Anzahl von Biegebeanspruchungen aushalten. Solche starre, nur in Teilbereichen biegbare Gedruckte Schaltungen bestehen ausschließlich aus starrem Leiterplattenmaterial (1), das in den biegbaren Bereichen (3) ganz oder teilweise eine geringere Dicke aufweist als in den übrigen Bereichen.

## Beschreibung

Die Erfindung betrifft starre, in Teilbereichen biegbare Gedruckte Schaltungen ausschließlich bestehend aus starren Leiterplattenmaterialien mit einer oder mehreren Leiterbahnebenen.

Schon seit vielen Jahren werden beispielsweise in Geräten und Fahrzeugen zur elektronischen Regelung und Steuerung Gedruckte Schaltungen eingesetzt. Es handelt sich hierbei üblicherweise um starre Leiterplatten, die einerseits diskrete Bauelemente und hochintegrierte Bausteine elektrisch miteinander verbinden und andererseits als Träger derselben fungieren. Die Leiterplatten bestehen zumeist aus einer oder mehreren Lagen von glasfaserverstärkten, ausgehärteten Epoxidharzplatten, die zur Ausbildung von Leiterbahnen ein- oder beidseitig kupferkaschiert sind und in den verschiedenen Ebenen elektrisch miteinander verbunden sein können.

Seit einigen Jahren werden Gedruckte Schaltungen eingesetzt, die nebeneinander starre und flexible Bereiche aufweisen. Dadurch kann eine größere Zahl von starren Leiterplatten in nahezu jeder gewünschten räumlichen Anordnung ohne Steckerleisten oder Verdrahtungen mechanisch und elektrisch miteinander verbunden werden. Die flexiblen Bereiche bestehen normalerweise aus dünnen Polyimidfolien, die ebenfalls ein- oder beiseitig kupferkaschiert sind.

Die aus starren und flexiblen Bereichen bestehenden Leiterplatten werden gewöhnlich aus übereinanderliegenden starren und flexiblen Einzellagen aufgebaut, die sich über die gesamte Schaltung erstrecken und mit Hilfe von Verbundfolien miteinander verklebt und verpresst sind. Es handelt sich hierbei um unbiegsame (z.B. glasfaserverstärktes Epoxidharz) und biegsame Isolationsträger (z.B. Polyimidfolie) mit ein- oder zweiseitigen Kupferkaschierungen, in die die Leiterbahnen geätzt werden. Die Form der starren Lagen legt den starren Teil der Leiterplatten fest. Die flexiblen Bereiche der Leiterplatten werden hergestellt, indem man in diesen Bereichen die starren Lagen in mehreren Verfahrensschritten entfernt. Ein solches Verfahren ist z. B. in der DE-PS 26 57 212 beschrieben. Die Herstellung solcher starr-flexiblen Leiterplatten

ist wegen der zahlreichen Verfahrensschritte und der Verwendung von relativ teuren Polyimidfolien sehr zeitaufwendig und kostenintensiv. In vielen Anwendungsfällen ist es aber gar nicht notwendig, daß die flexiblen Bereiche so flexibel sind, um hohen Dauerbiegebeanspruchungen ausgesetzt werden zu können. In vielen Fällen werden diese Bereiche nur beim Einbau in das Gerät oder Fahrzeug auf Biegung beansprucht und gegebenenfalls nochmals bei späteren Kontrollen oder Serviceleistungen. Diese Biegebeanspruchungen sind zahlenmäßig begrenzt und relativ klein.

Es war daher Aufgabe der vorliegenden Erfindung, starre, in Teilbereichen biegbare Gedruckte Schaltungen zu entwickeln,
die ausschließlich aus starren Leiterplattenmaterialien bestehen und mit möglichst wenigen Verfahrensschritten kostengünstig herstellbar sind.

Diese Aufgabe wird erfindungsgemäß dadurch gelöst, daß das starre Leiterplattenmaterial in den Bereichen, die biegbar sind, ganz oder teilweise eine geringere Dicke aufweist als in den übrigen Bereichen, und die geringere Dicke durch Materialabtrag entstanden ist.

Vorzugsweise besitzt das starre Leiterplattenmaterial in den biegbaren Bereichen eine Stärke von 0.05 bis 0,5 mm, wobei die obere Grenze etwas von der Steifigkeit bzw. Elastizität des starren Leiterplattenmaterials abhängig ist.

In bestimmten Fällen kann es vorteilhaft sein, als starres Leiterplattenmaterial Laminate zu verwenden, bei denen eine Außenlage aus einem Material mit etwas höherer Flexibilität besteht und im biegbaren Bereich die anderen Lagen durch Materialabtrag ganz oder teilweise entfernt sind.

Die Herstellung solcher starrer Leiterplatten, die biegsame Bereiche aufweisen, erfolgt in der Weise, daß die Leiterplatten in den Bereichen, die biegbar werden sollen, durch Materialabtrag auf eine geringere Dicke gebracht werden. Der Materialabtrag kann beispielsweise durch bekannte Verfahren, wie Fräsen, Räumen oder durch Lasermethoden erfolgen.

Dabei muß der Materialabtrag in den biegbaren Bereichen nicht gleichmäßig über die gesamte Fläche erfolgen, sondern es ist bei nicht allzugroßer Biegebeanspruchung ausreichend, wenn senkrecht zur ßiegerichtung beispielsweise mehrere Hute eingebracht sind.

Es hat sich überraschenderweise gezeigt, daß auch starres Leiterplattenmaterial biegbar wird, wenn es durch Materialabtrag auf genügend dünne Schichtstärken gebracht wird.

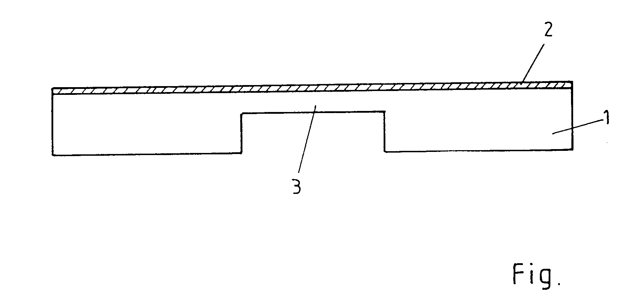

Die Abbildung zeigt schematisch im Längsschnitt eine starre Leiterplatte, die einen biegbaren Bereich (3) aufweist. Sie besteht durchgehend aus einem starren Material (1), beispielsweise glasfaserverstärktem Epoxidharz, das auf der einen Seite ein Leiterbahnmuster (2) aus Kupfer trägt. In dem Bereich (3) der biegbar sein soll, ist von der Rückseite der Leiterbahnauflage (2) her das starre Material bis auf eine verbleibende Schichtdicke von 0,05 bis etwa 0,5 mm entfernt.

Folgendes Beispiel soll die Erfindung näher erläutern:
Eine Leiterplatte der Größe 300 × 100 mm², Dicke 1,6 mm, aus glasfaserverstärktem Epoxidharz ist mit einer 35 µm starken Kupferschicht versehen. In der Mitte dieser Leiterplatte wird von der der Kupferschicht entgegengesetzten Seite her auf einer 2 Fläche von 30 × 100 mm² durch mechanisches Fräsen die Schichtdicke der Leiterplatte auf 0,2 mm reduziert. In diesem Bereich ist die Leiterplatte dann biegbar und überstand ein fünfzigmaliges Abbiegen um jeweils 90^{°} ohne erkennbare Beschädigungen in diesem Bereich.

Die Ausbildung der Leiterbahnen erfolgt nach bekannten Verfahren. Durch die relativ wenigen und einfachen Verfahrensschritte ist die Herstellung dieser Schaltungen kostengünstig.

## Patentansprüche

1. Starre, in Teilbereichen biegbare Gedruckte Schaltungen, ausschließlich bestehend aus starren Leiterplatenmaterialien mit einer oder mehreren Leiterbahnebenen,
dadurch gekennzeichnet,
daß das starre Leiterplattenmaterial in den Bereichen, die biegbar sind, ganz oder teilweise eine geringer Dicke aufweist als in den übrigen Bereichen, und daß die geringere Dicke durch Materialabtrag entstanden ist.

2. Gedruckte Schaltungen gemäß Anspruch 1
dadurch gekennzeichnet,
daß das starre Leiterplattenmaterial in den biebaren Bereichen eine Stärke von 0,05 bis 0,5 mm aufweist.

3. Gedruckte Schaltungen nach Anspruch 1 oder 2,
dadurch gekennzeichnet,
daß als Leiterplattenmaterial Laminate verwendet werden, bei denen eine Außenlage aus einem Material mit höherer Flexibilität besteht.

4. Verfahren zur Herstellung von Gedruckten Schaltungen nach Anspruch 1 bis 3,
dadurch gekennzeichnet.
daß die starren Leiterplatten in den Bereichen, die biegbar werden sollen, durch Materialabtrag ganz oder teilweise auf eine geringere Dicke gebracht werden.
